# EUROPÄISCHE PATENTANMELDUNG

(11) **EP 3 226 012 A1**
(43) Veröffentlichungstag der Anmeldung: **04.10.2017**
(21) Anmeldenummer: 17158654.8
(22) Anmeldetag: 01.03.2017
(51) Int. Cl.: G01R 11/04, G01R 22/06

(54) **EINRICHTUNG ZUM MESSEN DER ELEKTRISCHEN ENERGIE EINES WECHSELSTROMS**

(30) Priorität: 30.03.2016 DE 102016205179
(71) Anmelder: Siemens Aktiengesellschaft, 80333 München (DE)
(72) Erfinder: Tuma, Claus, 91207 Lauf/Peg. (DE)

(57) **Zusammenfassung**

Die Erfindung betrifft eine Einrichtung (1) zum Messen der Energie eines Wechselstroms, der durch einen im Gehäuse (2) als Leiterschleife ausgebildeten Verbindungsleiter (12) fließt, welcher zwei Anschlüsse (AZ1, AA1; AZ2, AA2; AZ3, AA3; AZ0, AA0) miteinander verbindet, mit einer Drahtwicklung (11), die auf einen Wicklungsträger gewickelt ist, durch den der Verbindungsleiter (12) verläuft, der zusammen mit der Drahtwicklung (11) einen Wandler bildet, an dessen Ausgang jeweils ein Wandlersignal vorhanden ist, und mit zumindest einer Leiterplatte (9), die mit einer Auswerteelektronik bestückt ist, welche jeweils mit dem Ausgang des Wandlers und den beiden Anschlüssen (AZ1, AA1; AZ2, AA2; AZ3, AA3; AZ0, AA0) verbunden ist und welche anhand des Wandlersignals und der Spannung zwischen den beiden Anschlüssen die Energie des Wechselstroms bestimmt. Um den Verbrauch von Leiterplattenfläche bei der Befestigung der Stromwandler zu verringern, wird vorgeschlagen, dass zumindest die beiden Anschlüsse (AZ1, AA1; AZ2, AA2; AZ3, AA3; AZ0, AA0), der Verbindungsleiter (12) und die Drahtwicklung (11) in einer separaten Baueinheit (6) in Form eines Anschlussblocks (6a) angeordnet sind.

## Beschreibung

Die Erfindung betrifft eine Einrichtung zum Messen der elektrischen Energie eines Wechselstroms gemäß dem Oberbegriff des Anspruchs 1.

Einrichtungen zum Messen der elektrischen Energie eines Wechselstroms sind insbesondere als PMDs (Power Monitoring Devices) bekannt. Derartige Messeinrichtungen befinden sich in einem Gehäuse, das pro Phase je einen Anschluss für den Energiezufluss und je einen Anschluss für den Energieabfluss aufweist, wobei die Anschlüsse direkt im Gehäuse angebracht und als von außen zugängliche Anschlussklemmen ausgebildet sind. Im Gehäuse ist weiter eine Leiterplatte angeordnet, auf welche der zu messende Wechselstrom übertragen wird, was meist durch auf die Leiterplatte gelötete Anschlussfahnen der Anschlussklemmen erfolgt. Dabei werden auch die zur Messung benötigten Stromwandler direkt auf der Leiterplatte befestigt, wobei sie aber entsprechend viel Leiterplattenfläche verbrauchen. Die Drahtwicklungen (Sekundärwicklungen) der Stromwandler sind je nach Messbereich relativ groß und schwer; sie werden deshalb in kammerförmige Wandlergehäuse, die an der Leiterplatte befestigt sind, eingelegt oder eingeklebt. Von der Leiterplatte aus wird jeweils ein schlaufenförmig gebogener Primärdraht durch die Drahtwicklung geführt, die im Wesentlichen die Form eines Hohlzylinders hat. Der Primärdraht verbindet jeweils die beiden zugeordneten Anschlüsse miteinander.

Anhand der von den Stromwandlern generierten Spannung ermittelt eine Signaleinheit jeweils die elektrische Energie (den Energiefluss) des Wechselstroms.

Nachteilig bei dieser Einrichtung ist die Art und Weise der Befestigung der Stromwandler, durch die insbesondere relativ viel Leiterplattenfläche verbraucht wird.

Aufgabe der Erfindung ist es, die damit verbundenen Nachteile zu überwinden.

Die Aufgabe wird durch die Merkmale des Anspruchs 1 gelöst; die Unteransprüche stellen vorteilhafte Ausgestaltungen dar.

Die Lösung sieht vor, dass die beiden Anschlüsse, der Verbindungsleiter, der die beiden Anschlüsse direkt verbindet, und die Drahtwicklung in einer separaten Baueinheit in Form eines Anschlussblocks angeordnet sind. Der Anschlussblock und die Leiterplattesind unabhängig voneinander in der Einrichtung (im Gehäuse der Einrichtung) befestigt. Der separate Anschlussblock nimmt also die Anschlüsse als auch die Stromwandler auf. Das ermöglicht es, die durch die äußere Form der Einrichtung vorgegebene Größe der Leiterplatte besser auszunutzen. Weiter wird durch den separaten Anschlussblock auf der Leiterplatte Platz für andere Komponenten geschaffen. Da der Verbindungsleiter im Anschlussblock jeweils auf kürzestem Wege von dem einen Anschluss durch den Wandler direkt zu dem anderen Anschluss verläuft, da also die zu messenden Primärströme (von z.B. 65 A) nicht mehr über die Leiterplatte geführt werden, verringert sich die Strombelastung der Leiterplatte erheblich. Ein weiterer Vorteil besteht darin, dass der Anschlussblock unabhängig von der Einrichtung vorgefertigt werden kann; beim Zusammenbau der Einrichtung wird der Anschlussblock z.B. nur aufgesteckt.

Die Erfindung wird nachfolgend anhand eines Ausführungsbeispiels näher beschrieben. Es zeigen:
- Fig. 1: eine Einrichtung zum Messen der elektrischen Energie eines mehrphasigen Wechselstroms,
- Fig. 2: die Einrichtung gemäß Fig. 1 ohne die Gehäuseabdeckung,
- Fig. 3: das Gehäuseunterteil, eine zweite untere Leiterplatte 9 und den Gehäuseblock 6a der Einrichtung gemäß Fig. 2 als Explosionsdarstellung und
- Fig. 4: den Anschlussblock gemäß Fig. 2 und 3 von oben gesehen.

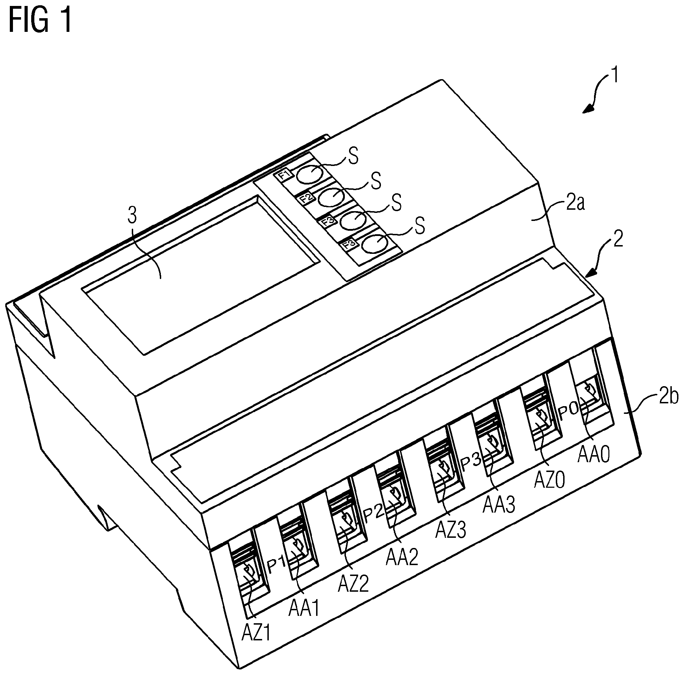

Fig. 1 zeigt eine Einrichtung 1 zum Messen der elektrischen Energie eines mehrphasigen Wechselstroms. Die Einrichtung 1 weist ein Gehäuse 2 auf, das aus einer Gehäuseabdeckung 2a und einem Gehäuseunterteil 2b gebildet ist. Auf der Oberseite der Gehäuseabdeckung 2a befindet sich ein Display 3 zur Anzeige insbesondere der gemessenen Energie. Daneben befinden sich Stellelemente S, mit denen die gewünschten Einstellungen der Einrichtung 1 vorgenommen werden können.

Für jede der drei Phasen P1, P2, P3 ist jeweils ein von außen zugänglicher Anschluss AZ1, AZ2, AZ3 für den Energiezufluss und ein Anschluss AA1, AA2, AA3 für den Energieabfluss vorhanden, für den Neutralleiter P0 entsprechend je ein Anschluss AZ0 und ein Anschluss AA0.

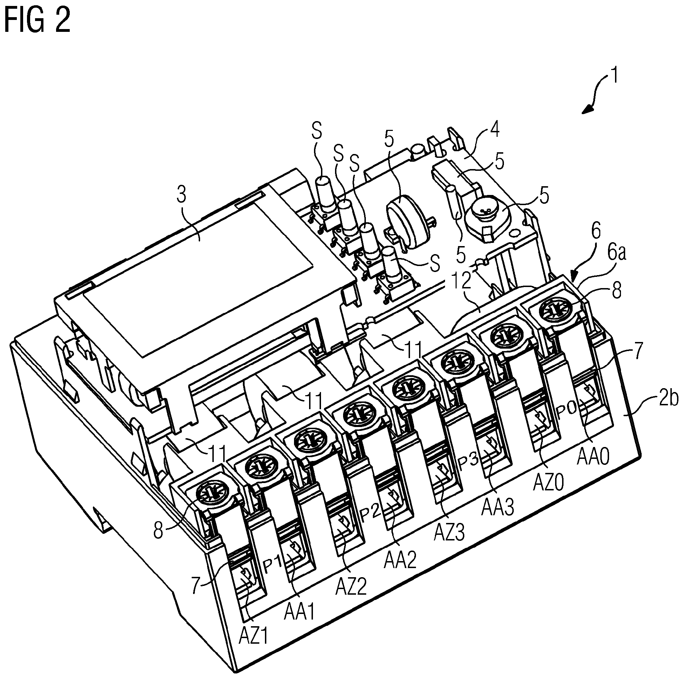

Fig. 2 zeigt die Einrichtung 1 ohne die Gehäuseabdeckung 2a. Man erkennt eine erste obere Leiterplatte 4 mit mehreren Bauelementen 5 sowie die auf der Leiterplatte 4 angeordneten Stellelemente 5. Weiter befindet sich im Gehäuseunterteil 2b eine separate Baueinheit 6 in Form eines Anschlussblocks 6a, in dem die Anschlüsse AZ1, AZ2, AZ3, AZ0 und die Anschlüsse AA1, AA2, AA3, AA0 paarweise nebeneinander fest angeordnet sind. Jeder Anschluss AZ1, AZ2, AZ3, AZ0, AA1, AA2, AA3, AA0 ist hier speziell als Anschlussklemme 7 ausgebildet, in der nicht gezeigte Anschlusskabel mittels einer Schraube 8 festklemmbar und so mit der Einrichtung 1 verbindbar sind.

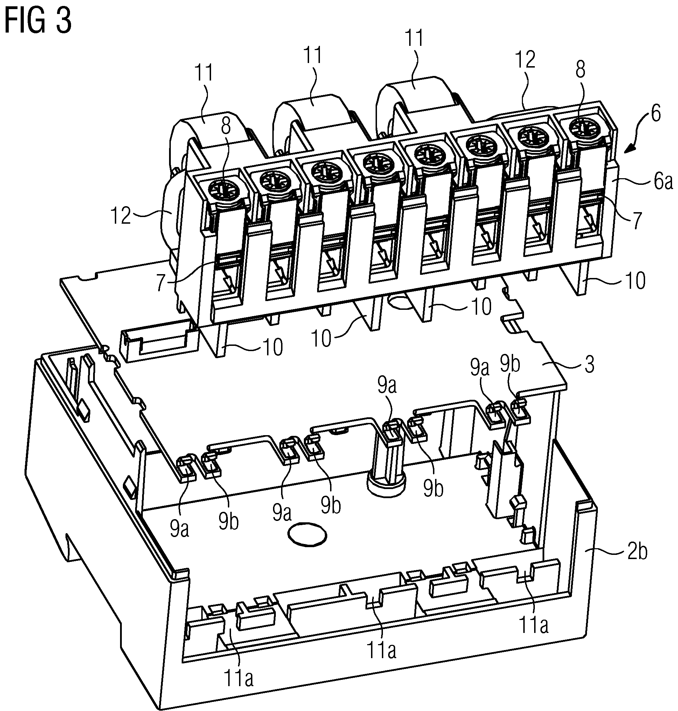

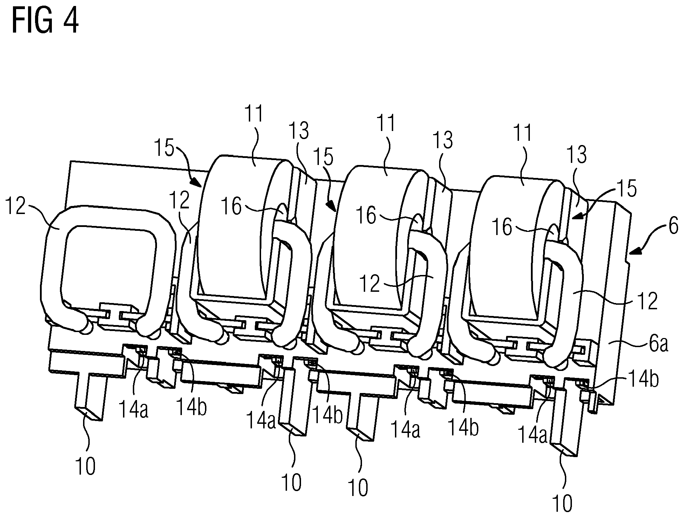

Fig. 3 zeigt das Gehäuseunterteil 2b, eine zweite untere Leiterplatte 9 und den Anschlussblock 6a als Explosionsdarstellung, wobei der Übersichtlichkeit halber in Fig. 3 nur diese drei Elemente der Einrichtung 1 gezeigt sind. Der Anschlussblock 6a ist mit Befestigungselementen 10 in Form von abstehenden plattenförmigen Steckelementen versehen, die in entsprechende Aufnahmen 11a im Gehäuseunterteil 2b zur Befestigung des Anschlussblocks 6a einsteckbar sind. Die Befestigung des Anschlussblocks 6a erfolgt dabei unabhängig von der Leiterplatte 9 (und auch der Leiterplatte 4). An der unteren Leiterplatte 9 vorhandene federnde Kontaktelemente (Federkontakte) 9a, 9b liegen im montierten Zustand an entsprechend angeordneten Kontaktflächen 14a, 14b (s. Fig.4) des Anschlussblocks 6a Federdruck beaufschlagt an, wobei sie eine elektrische Verbindung mit den Anschlussklemmen 7 (also jeweils mit den Paaren von Anschlüssen AZ1 und AA1, AZ2 und AA2, AZ3 und AA3, AZ0 und AA0) herstellen und so ein Abgreifen der zwischen den Anschlusspaaren anliegenden (abfallenden) Spannung ermöglichen.

Der Anschlussblock 6a weist hier mehrere nebeneinanderliegende Kammern auf, in denen für jede Phase je eine Drahtwicklung 11 eingelegt ist, deren unterer Teil sich in die Kammer erstreckt, während sich der obere Teil außerhalb der Kammer befindet. Jede Drahtwicklung 11 hat die Form eines Hohlzylinders, durch dessen Hohlraum jeweils ein Verbindungsleiter 12 in Form einer einfachen Leiterschleife geführt ist. Der Verbindungsleiter 12 verbindet jeweils die zugehörigen Anschlusspaare AZ1 und AA1, AZ2 und AA2, AZ3 und AA3 sowie AZ0 und AA0 miteinander und bildet zusammen mit der Drahtwicklung 11 jeweils einen Wandler (Stromwandler) 15. Die Enden des Verbindungsleiters 12 sind dabei jeweils direkt mit den zugehörigen Anschlüssen AZ1 und AA1, AZ2 und AA2, AZ3 und AA3, AZ0 und AA0 (Käfigklemmen 7) verbunden.

Fig. 4 zeigt den Anschlussblock 6a von oben gesehen. Man erkennt den Verbindungsleiter 12, der bei den drei Drahtwicklungen 11 jeweils durch einen zylindrischen Hohlraum 16 der Drahtwicklung 11 geführt ist. Für den Verbindungsleiter 12 des Neutralleiters P0 (ganz links in Fig. 4) ist keine Drahtwicklung 11 und damit kein Wandler 15 vorgesehen. In Fig. 4 sind insbesondere die unten liegenden Kontaktflächen 14a, 14b des Anschlussblocks 6a gut zu erkennen.

## Patentansprüche

1. Einrichtung (1) zum Messen der elektrischen Energie eines Wechselstroms, der durch einen im Gehäuse (2) der Einrichtung (1) als Leiterschleife ausgebildeten Verbindungsleiter (12) fließt, welcher zwei von außen zugängliche und auf derselben Seite liegende Anschlüsse (AZ1, AA1; AZ2, AA2; AZ3, AA3; AZ0, AA0) miteinander verbindet,
mit einer Drahtwicklung (11), die auf einen hohlkörperartigen Wicklungsträger gewickelt ist, durch den der Verbindungsleiter (12) verläuft, der zusammen mit der Drahtwicklung (11) einen Wandler bildet, an dessen Ausgang durch elektromagnetische Kopplung jeweils ein dem Wechselstrom entsprechendes Wandlersignal vorhanden ist, und mit zumindest einer Leiterplatte (9), die mit einer Auswerteelektronik bestückt ist, welche jeweils mit dem Ausgang des Wandlers und den beiden Anschlüssen (AZ1, AA1; AZ2, AA2; AZ3, AA3; AZ0, AA0) verbunden ist und welche anhand des Wandlersignals und der Spannung zwischen den beiden Anschlüssen die Energie des Wechselstroms bestimmt,
**dadurch gekennzeichnet,**
**dass** zumindest die beiden Anschlüsse (AZ1, AA1; AZ2, AA2; AZ3, AA3; AZ0, AA0), der die beiden Anschlüsse (AZ1, AA1; AZ2, AA2; AZ3, AA3; AZ0, AA0) direkt verbindende Verbindungsleiter (12) und die Drahtwicklung (11) in einer separaten Baueinheit (6) in Form eines Anschlussblocks (6a) angeordnet sind, der unabhängig von der zumindest einen Leiterplatte (9) in der Einrichtung (1) befestigt ist.

2. Einrichtung nach Anspruch 1,
**dadurch gekennzeichnet,**
**dass** die Drahtwicklung (11) jeweils in einer Kammer (13) angeordnet ist.

3. Einrichtung nach Anspruch 1 oder 2,
**dadurch gekennzeichnet,**
**dass** der Anschlussblock (6a) Befestigungselemente (10) aufweist, die in entsprechende Aufnahmen (11a) im Gehäuseunterteil (2b) zur Befestigung des Anschlussblocks (6a) einsteckbar sind.

4. Einrichtung nach einem der Ansprüche 1 bis 3,
**dadurch gekennzeichnet,**
**dass** die Befestigungselemente (10) in Form von plattenförmigen oder stegförmigen Steckelementen ausgebildet sind.

5. Einrichtung nach einem der Ansprüche 1 bis 4,
**dadurch gekennzeichnet,**
**dass** an der Leiterplatte (9) federnde Kontaktelemente (9a, 9b) vorhanden sind, die an entsprechend angeordneten Kontaktflächen (14a, 14b) des Anschlussblocks (6a) anliegen.
